# EUROPÄISCHE PATENTSCHRIFT

(11) **EP 1 035 646 B1**
(45) Veröffentlichungstag und Bekanntmachung des Hinweises auf die Patenterteilung: **03.12.2003**
(21) Anmeldenummer: 00104271.2
(22) Anmeldetag: 01.03.2000
(51) Int. Cl.: H03G 3/00, H03K 17/16

(54) **Schaltung für einen steuerbaren Verstärker**
Circuit for a controllable amplifier
Circuit pour un amplificateur réglable

(30) Priorität: 05.03.1999 DE 19909773
(43) Veröffentlichungstag der Anmeldung: 13.09.2000
(73) Patentinhaber: Infineon Technologies AG, 81669 München (DE)
(72) Erfinder: Matter, Udo, 40489 Düsseldorf (DE); Van Waasen, Stefan Dr., 47178 Duisburg (DE); Lipuma, Giuseppe, 44791 Bochum (DE)
(74) Vertreter: Epping Hermann & Fischer

(56) Entgegenhaltungen:
- EP-A- 0 612 144
- EP-A- 0 661 804
- US-A- 4 151 481
- US-A- 4 574 251
- US-A- 4 751 497
- VERHOEVEN J T M ET AL: "A SOFTWARE CONTROLLABLE TIME-GAIN-COMPENSATION AMPLIFIER BOARD FOR VMEBUS SYSTEMS" ULTRASONICS,GB,IPC SCIENCE AND TECHNOLOGY PRESS LTD. GUILDFORD, Bd. 30, Nr. 6, 1. Januar 1992 (1992-01-01), Seiten 407-408, XP000329694 ISSN: 0041-624X
- PATENT ABSTRACTS OF JAPAN vol. 1998, no. 06, 30. April 1998 (1998-04-30) -& JP 10 041766 A (NEW JAPAN RADIO CO LTD), 13. Februar 1998 (1998-02-13)

## Beschreibung

Die Erfindung betrifft eine Verstärkerschaltvorrichtung zum Schalten eines durch einen Referenzstrom gesteuerten Verstärkers.

Übertragungssysteme im Kommunikationsbereich verwenden verschiedene Multiplextechniken zur mehrfachen Ausnutzung eines Übertragungsweges durch mehrere Kanäle. Beim Frequenzmultiplexverfahren werden die einzelnen Kanäle in verschiedenen, nebeneinanderliegenden Frequenzbereichen gleichzeitig übertragen, während beim Zeitmultiplexverfahren die einzelnen Kanäle periodisch abgetastet und zeitlich nacheinander übertragen werden. Verschiedene Übertragungssysteme verwenden auch eine Kombination aus Frequenzmultiplex- und Zeitmultiplexverfahren.

Bei digitalen Zeitmultiplex-Übertragungssystemen, wie beispielsweise dem DECT (Digital European Cordless Telecommunications), wird der Kanal zum Senden und Empfangen von Informationen in eine Vielzahl von Rahmen (frame) unterteilt, wobei jeder Rahmen seinerseits wieder aus mehreren Zeitschlitzen (time slots) besteht. Beispielsweise besitzt das DECT-System Rahmen, die aus 24 Zeitschlitzen mit einer Dauer von je 416 Mikrosekunden bestehen. Von diesen 24 Zeitschlitzen sind 12 Zeitschlitze für den Empfangsbetrieb und die anderen 12 Zeitschlitze für den Sendebetrieb reserviert.

Zu Beginn eines aktiven Sendezeitschlitzes wird die Ausgangsverstärkerstufe eines Endgeräts des Übertragungssystems für den Sendebetrieb eingeschaltet. Hierzu muß die Ausgangsverstärkerstufe entsprechend dem jeweiligen Übertragungssystemstandard innerhalb eines vorbestimmten Zeitfensters auf eine vorbestimmte Sendeleistung hochgefahren werden, damit anschließend die Informationsdaten innerhalb des Zeitschlitzes ausgesendet werden können.

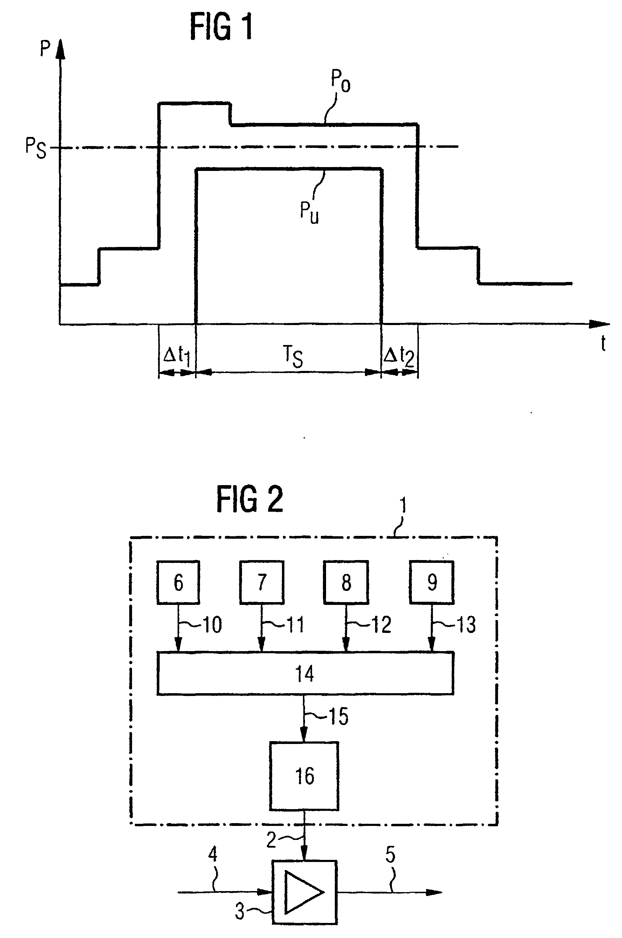

Fig. 1 zeigt schematisch ein Leistungsprofil für einen Zeitmultiplex-Übertragungsstandard. Die Ausgangsleistung P der Ausgangsverstärkerstufe muß sich innerhalb eines Korridors bewegen, welche durch eine obere zulässige Leistung PO und eine untere zulässige Leistung PU definiert ist. Gemäß dem Standard muß dabei die Sendeleistung der Ausgangsverstärkerstufe beim Einschalten innerhalb eines Zeitfensters Δt₁ von einer niedrigen Ausgangsleistung auf eine mittlere Sendeleistung Pₛ hochgefahren werden. Sobald die Sendeleistung Pₛ erreicht ist, können innerhalb eines Zeitfensters Tₛ Daten übertragen werden. Nach dem Senden wird die Ausgangsverstärkerstufe innerhalb eines Ausschaltzeitschlitzes Δt₂ wieder auf die niedrigere Leistung heruntergefahren. Bei dem DECT-Übertragungssystem beträgt die Dauer der beiden Zeitfenster beispielsweise 10 µs.

Das Hochfahren der Ausgangsverstärkerstufe während des Einschaltzeitschlitzes Δt₁ bzw. das Herunterfahren der Ausgangsverstärkerstufe während des Ausschaltzeitschlitzes Δt₂ darf jedoch nicht zum Aussenden von unerlaubten Störsignalen in ein benachbartes Frequenzspektrum führen. Das Signal sollte lediglich Frequenzanteile innerhalb eines vorbestimmten spektralen Fensters aufweisen, d.h. innerhalb einer niedrigen Grenzfrequenz fᵤ und einer oberen Grenzfrequenz fₒ. Aus diesem Grunde muß der Signalverlauf der Ausgangsleistung P der Ausgangsverstärkerstufe während des Einschalt- bzw. Ausschaltvorganges möglichst glatt und rund sein. Ein derartig glatter und runder Signalverlauf bedeutet, daß keine allzu hohen störenden hochfrequenten Signalanteile vorhanden sind.

Bei den bisherigen Übertragungssystemen wurde versucht, mittels eines externen Kondensators einen derartigen glatten und runden Signalverlauf beim Hoch- bzw. Herunterfahren der Ausgangsverstärkerstufe zu erreichen. Hierbei wird der externe Kondensator über einen Konstantstrom auf- bzw. entladen. Die Spannung an dem Kondensator steigt linear an und schaltet die Biasstufe für die Stromversorgung der Ausgangsverstärkerstufe ein bzw. aus. Der zeitliche Signalverlauf der Ausgangsleistung ist jedoch nicht genügend glatt, da der Stromanstieg in der Ausgangsverstärkerstufe durch die nichtlineare Transistorkennlinie vorgegeben ist. Bei Bipolartransistoren besteht beispielsweise ein exponentieller Zusammenhang zwischen Spannung und Strom. Die nichtlineare Transistorkennlinie führt zu störenden Signalanteilen im Frequenzspektrum.

Ein weiterer Nachteil derartiger Übertragungssysteme besteht darin, daß die Zeitfenster zum Ein- und Abschalten der Ausgangsverstärkerstufe nur sehr ungenau eingestellt werden können. Die Kapazität des Kondensators bestimmt zwar im wesentlichen die Zeitdauer des Ein- und Abschaltvorganges, jedoch unterliegt diese ebenfalls den Eigenschaften der nichtlinearen Transistorkennlinie. Bei vielen Anwendungen im Kommunikationsbereich, wie beispielsweise bei GSM, werden daher oft komplizierte Steuer- bzw. Regelverfahren eingesetzt, um die Probleme aufgrund der nichtlinearen Transistorkennlinie zu vermeiden. Derartige Steuerverfahren benötigen eine aufwendige digitale Steuerlogik.

Es ist daher die Aufgabe der vorliegenden Erfindung, eine Schaltvorrichtung zum Schalten der Verstärkerstufe zu schaffen, die einen glatten und runden Signalverlauf beim Ein- und Ausschalten der Verstärkerstufe gewährleistet, wobei die Zeitfenster zum Ein- und Ausschalten exakt einstellbar sind und die Schaltvorrichtung gleichzeitig mit einem geringen technischen Aufwand herstellbar ist.

Diese Aufgabe wird erfindungsgemäß durch eine Vorrichtung mit den im Patentanspruch 1 angegebenen Merkmalen gelöst.

Weitere vorteilhafte Ausgestaltungen der Erfindung ergeben sich aus den abhängigen Ansprüchen.

Die Erfindung schafft eine Vorrichtung zum Schalten eines durch einen Referenzstrom gesteuerten Verstärkers, wobei die Vorrichtung mehrere Stromquellen besitzt, deren jeweilige Ausgangsströme durch eine Summationsschalteinrichtung zur Erzeugung eines Summenstromes aufsummiert werden, wobei die hochfrequenten Signalanteile des Summenstroms zur Erzeugung des Referenzstromes durch eine nachgeschaltete Filtereinrichtung herausgefiltert werden.

Die Summationsschalteinrichtung weist mehrere parallel geschaltete steuerbare Schalter auf, die jeweils mit einer Stromquelle verbunden sind.

Dies bietet den Vorteil, daß die Bildung des Summenstroms mit einem schaltungstechnisch geringen Aufwand ermöglicht wird.

Die Schalter der Summationsschalteinrichtung sind jeweils über eine Steuerleitung mit einer Steuerschaltung verbunden.

Dies bietet den Vorteil, daß die Schalter unabhängig voneinander schaltbar sind und die Ausgangsströme der Stromquellen in beliebiger Kombination miteinander aufsummiert werden können.

Die Steuerschaltung besteht aus einem Schieberegister.

Die bietet den Vorteil, daß eine Steuerschaltung mit einfachen technischen Mitteln eine robuste und zuverlässige Steuerung der Schalter gewährleistet.

Bei einer weiteren vorteilhaften Ausgestaltung der erfindungsgemäßen Schaltvorrichtung besteht das Schieberegister aus kettenförmig ineinandergeschalteten Multivibratoren bzw. Flip-Flops, wobei deren jeweilige logische Singnalausgänge jeweils mit einer Steuerleitung eines zugehörigen Schalters verbunden sind.

Bei einer weiteren vorteilhaften Ausgestaltung der erfindungsgemäßen Schaltvorrichtung sind die Flip-Flops flankengetriggerte D-Flip-Flops.

Bei einer weiteren vorteilhaften Ausgestaltung der erfindungsgemäßen Schaltvorrichtung sind die Takteingänge der D-Flip-Flops über eine Taktleitung an eine Takterzeugungseinrichtung angeschlossen.

Bei einer weiteren vorteilhaften Ausgestaltung der erfindungsgemäßen Schaltvorrichtung ist an den Schieberegistereingang des ersten Schieberegister-Flip-Flops ein Steuersignal anlegbar, das zwischen einem ersten logischen Zustand zum Einschalten des Verstärkers und einem zweiten logischen Zustand zum Ausschalten des Verstärkers umschaltbar ist.

Bei einer weiteren vorteilhaften Ausgestaltung der erfindungsgemäßen Schaltvorrichtung weist die Filtereinrichtung mindestens einen RC-Tiefpaßfilter auf.

Die bietet den Vorteil einer technisch einfachen, aber zuverlässigen und wirksamen Signalfilterung.

Bei einer weiteren vorteilhaften Ausgestaltung der erfindungsgemäßen Schaltvorrichtung wird aus dem an dem Tiefpaßfilter anliegenden Summenstrom eine Spannung erzeugt, die durch einen Spannungsstromwandler in den Referenzstrom zur Ansteuerung des Verstärkers umgewandelt wird.

Bei einer weiteren vorteilhaften Ausgestaltung der erfindungsgemäßen Schaltvorrichtung ist die Höhe der durch die Stromquellen erzeugten Ausgangsströme jeweils einstellbar.

Dies bietet den besonderen Vorteil, daß die Ausgangsströme an die speziellen Anforderungen der Verstärkerstufe sowie an die gewünschte Signalverlaufsform angepaßt werden können.

Bei einer weiteren vorteilhaften Ausgestaltung der erfindungsgemäßen Schaltvorrichtung verstärkt der Verstärker ein digitales Zeitmultiplexsignal.

Bei einer weiteren vorteilhaften Ausgestaltung der erfindungsgemäßen Schaltvorrichtung weist das Zeitmultiplexsignal mehrere Signalrahmen auf, die jeweils in Zeitschlitze unterteilt sind.

Bei einer weiteren vorteilhaften Ausgestaltung der erfindungsgemäßen Schaltvorrichtung besitzt jeder Zeitschlitz ein Einschaltzeitfenster und ein Ausschaltzeitfenster.

Bei einer weiteren vorteilhaften Ausgestaltung der erfindungsgemäßen Schaltvorrichtung ist der Verstärker innerhalb der Zeitfenster zwischen einem ersten Leistungspegel und einem zweiten Leistungspegel umschaltbar.

Bei einer weiteren vorteilhaften Ausgestaltung der erfindungsgemäßen Schaltvorrichtung beträgt die Dauer eines Zeitfensters 10 µs.

Bei einer weiteren vorteilhaften Ausgestaltung der erfindungsgemäßen Schaltvorrichtung ist der Verstärker ein Sendesignalverstärker, dessen Ausgang mit einer Sendeantenne verbunden ist.

Im weiteren wird eine bevorzugte Ausführungsform der erfindungsgemäßen Schaltvorrichtung unter Bezugnahme auf die beigefügten Zeichnungen zur Erläuterung erfindungswesentlicher Merkmale beschrieben.

Es zeigen:
- Fig. 1: eine schematische Ansicht eines Leistungspegelverlaufs eines Ausgangsverstärkers gemäß einem Übertragungssystem-Zeitmultiplexstandard;
- Fig. 2: ein schematisches Blockschaltbild einer bekannten Schaltvorrichtung;
- Fig. 3: eine bevorzugte Ausführungsform der erfindungsgemäßen Schaltvorrichtung;
- Fig. 4: den Signalverlauf des durch die Summationsschalteinrichtung erzeugten Summenstroms zur Erläuterung der Funktionsweise der erfindungsgemäßen Schaltvorrichtung.

Fig. 1 zeigt ein Ausgangsleistungspegeldiagramm, das ein Verstärker gemäß einem vordefinierten Zeitmultiplexstandard erfüllen muß. Der Ausgangs- bzw. Sendeverstärker muß dabei innerhalb eines Zeitfensters Δt₁ auf eine Sendeleistung Pₛ hochgefahren werden, damit innerhalb eines Zeitmultiplex-Zeitschlitzes mit der Zeitdauer Tₛ Signaldaten übertragen werden können. Beim Ausschalten muß der Ausgangsverstärker innerhalb eines Ausschalt-Zeitfensters Δt₂ von dem Signalleistungspegel Pₛ wieder heruntergefahren werden. Der Ausgangssignalleistungspegel muß sich auf jeden Fall innerhalb eines Korridors bewegen, welcher durch eine untere Leistungspegellinie Pᵤ und eine obere Signalleistungspegellinie Pₒ bestimmt ist. Dabei muß das Ausgangsleistungssignal innerhalb des Einschaltzeitfensters Δt₁ und des Ausschaltzeitfensters Δt₂ einen möglichst glatten bzw. runden Signalverlauf nehmen, um störende Signalanteile zu vermeiden.

Fig. 2 zeigt ein Blockschaltbild einer aus dem Dokument US-A-4 151 481 bekannten Schaltvorrichtung.

Die bekannte Schaltvorrichtung 1 ist über eine Referenzstromleitung 2 mit einem Verstärker 3 verbunden. Der Verstärker 3 ist ein Sendeverstärker, welcher ein an einer Eingangsleitung 4 anliegendes Signal verstärkt und über eine Ausgangssignalleitung 5 abgibt. Die Verstärkung durch den Verstärker 3 erfolgt entsprechend der Höhe des über die Referenzstromleitung 2 zugeführten Referenzstromes.

Die in Fig. 2 gezeigte bekannte Schaltvorrichtung 1 weist mehrere Stromquellen 6, 7, 8, 9 auf. In dem gezeigten Beispiel sind vier Stromquellen vorgesehen. Bei der praktischen Umsetzung kann eine wesentlich höhere Anzahl an Stromquellen mit unterschiedlichen Ausgangsströmen vorgesehen sein. Die Stromquellen 6, 7, 8, 9 sind über Leitungen 10, 11, 12, 13 mit einer Summationsschalteinrichtung 14 verbunden, die über eine Summenstromleitung 15 an einer Filtereinrichtung 16 angeschlossen ist. Die Summationsschalteinrichtung 14 summiert die über die Leitungen 10, 11, 12, 13 zugeführten Ausgangsströme der Stromquellen 6, 7, 8, 9 auf und gibt den aufsummierten Strom über die Summenstromleitung 15 an die Filtereinrichtung 16 ab. Die Filtereinrichtung 16 filtert die hochfrequenten Signalanteile des Summenstromes heraus und gibt einen Referenzstrom an den Verstärker 3 ab.

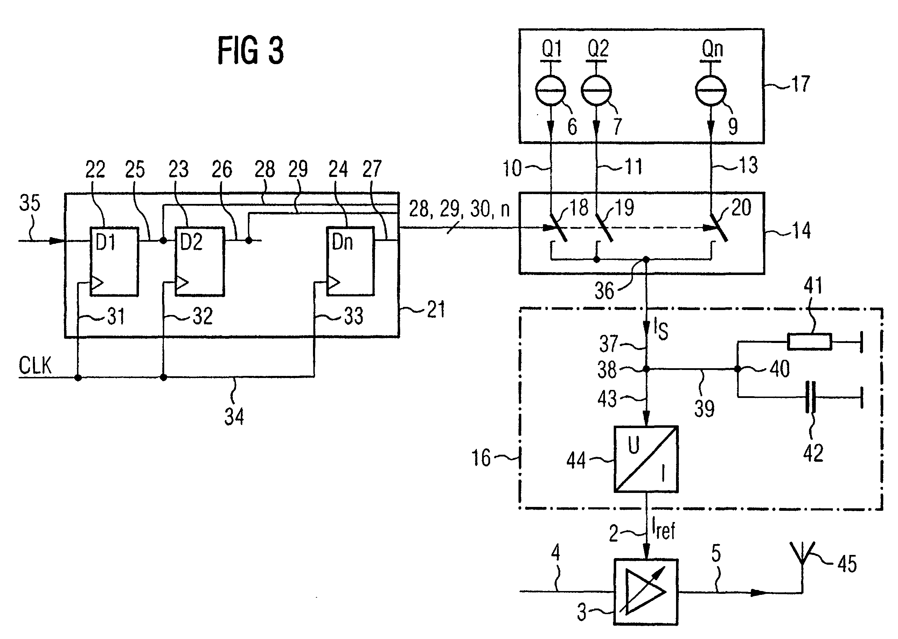

Fig. 3 zeigt eine bevorzugte Ausführungsform der erfindungsgemäßen Schaltvorrichtung.

Eine Stromquelleneinrichtung 17 weist mehrere parallel geschaltete Einzelstromquellen 6, 7, 9 auf, die jeweils über zugehörige Ausgangsstromleitungen 10, 11, 13 mit der Summationsschalteinrichtung 14 verbunden sind. Die Summationsschalteinrichtung 14 weist mehrere parallel geschaltete steuerbare Schalter 18, 19, 20 auf, die jeweils mit einer der Stromquellen 6, 7, 9 über die zugehörigen Stromleitungen 10, 11, 13 verbunden sind. Die steuerbaren Schalter 18, 19, 20 der Summationsschalteinrichtung 14 sind jeweils über eigene Steuerleitungen mit einer Steuerschaltung 21 verbunden. Die Steuerschaltung 21 ist bei der in Fig. 3 gezeigten bevorzugten Ausführungsform ein Schieberegister. Das Schieberegister besteht dabei aus kettenförmig hintereinandergeschalteten Flip-Flops 22, 23, 24, deren jeweilige logische Signalausgänge 25, 26, 27 jeweils an eine Steuerleitung 28, 29, 30 eines zugehörigen Schalters 18, 19, 20 angeschlossen sind. Die logischen Signalausgänge 25, 26 der kettenförmig hintereinandergeschalteten Flip-Flops sind jeweils mit dem logischen Eingang des nachgeschalteten Flip-Flops verbunden. Das in Fig. 3 gezeigte Schieberegister 21 besteht aus kettenförmig hintereinandergeschalteten flankengetriggerten D-Flip-Flops, deren Takteingänge 31, 32, 33 über eine Taktleitung 34 an eine Takterzeugungseinrichtung angeschlossen sind, die ein Systemtaktsignal erzeugt. Der logische Eingang des ersten D-Flip-Flops 22 des Schieberegisters 21 liegt an einer Steuersignalleitung 35 an.

Die Summationsschalteinrichtung 14 besitzt einen Summenknoten 36, der an den Schaltern 18, 19, 20 angeschlossen ist. Der Summenknoten 36 ist über eine Leitung 37 mit einem weiteren Knoten 38 innerhalb der Filtereinrichtung 16 verbunden. Der Knoten 38 liegt über eine Leitung 39 an einem Knoten 40 innerhalb der Filtereinrichtung 16 an. An den Knoten 40 ist ein Widerstand 41 und ein Kondensator 42 angeschlossen, die jeweils geerdet sind. Der Knoten 38 liegt über eine Leitung 43 an einem Spannungs-/Stromwandler 44 an, der über die Referenzstromleitung einen Referenzstrom an den Verstärker 3 abgibt.

Im weiteren wird die Funktionsweise der in Fig. 3 beschriebenen bevorzugten Ausführungsform der erfindungsgemäßen Schaltvorrichtung beschrieben.

Zum Einschalten des Ausgangsverstärkers 3 liegt an der Steuerleitung 35 ein logisches Eingangssignal an, das den logischen Wert "1" einnimmt. Mit dem über die Taktsignalleitung 34 anliegenden Systemtaktsignal wird das an der Steuerleitung 35 anliegende logische Eingangssignal, das den Wert "1" einnimmt, in das Schieberegister 21 eingeschoben, so daß nach dem ersten Takt an dem logischen Ausgang 25 des ersten Flip-Flops 22 eine logische "1" anliegt. Hierdurch wird der erste Schalter 18 der Summationsschalteinrichtung 14 über die Steuerleitung 28 eingeschaltet, so daß der Ausgangsstrom der ersten Stromquelle 6 an dem Summenknoten 36 anliegt.

Bei dem nächsten Takt wird die logische "1" weiter in das Schieberegister 21 geschoben, so daß auch an dem logischen Ausgang 26 des zweiten Flip-Flops 23 ein logisch hoher Wert anliegt. Hierdurch wird zusätzlich neben dem Schalter 18 auch der Schalter 19 der Summationsschalteinrichtung 14 geschlossen, so daß der Ausgangsstrom der zweiten Stromquelle 7 über die Leitung 11 an dem Summationsknoten 36 anliegt.

Nach einer vorbestimmten Anzahl von Taktimpulsen liegen alle logischen Ausgänge 25, 26, 27 des Schieberegisters 21 auf einem hohen logischen Wert "1", so daß alle Schalter 18, 19, 20 der Summationsschalteinrichtung 14 geschlossen sind und alle Ausgangsströme der Stromquellen 6, 7, 9 an dem Summenknotenpunkt 36 zusammengeführt werden.

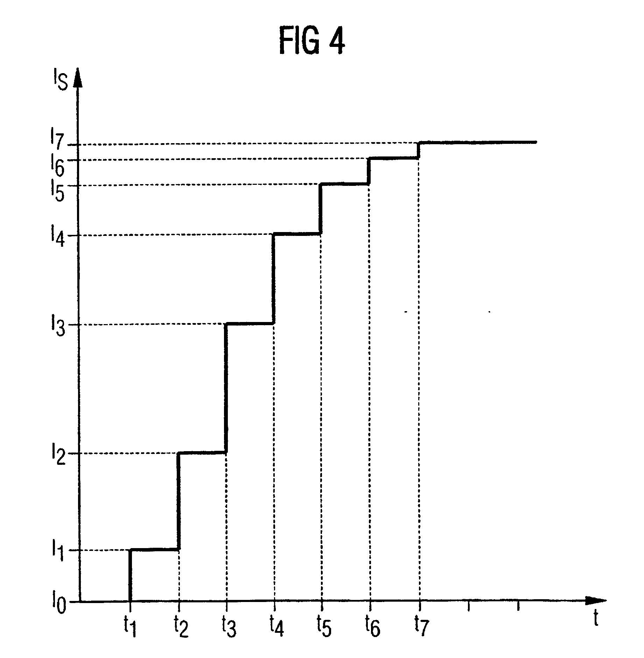

Fig. 4 zeigt beispielhaft den Signalverlauf des Summenstromes, der von dem Summenknotenpunkt 36 hin zu dem Knoten 38 über die Leitung 37 fließt. Nach dem Schließen des ersten Schalters 18 zum Zeitpunkt t₁ fließt der Ausgangsstrom I₁ der ersten Stromquelle 6 und wird nach dem Zuschalten des zweiten Schalters 19 zum Zeitpunkt t₂ auf den Stromwert I₂ erhöht. Bei dem in Fig. 4 gezeigten Beispiel sind sieben Stromquellen vorgesehen, die nacheinander zugeschaltet werden. Die Höhe der durch die Stromquellen abgegebenen Ströme ist einstellbar, so daß die Stufen des in Fig. 4 gezeigten Summenstroms beliebig groß sein können. Hierdurch ist ein beliebiger gewünschter Signalverlauf einstellbar. Beispielsweise kann ein linearer, exponentieller oder gaußförmiger Signalverlauf durch entsprechende Einstellung und Anzahl von Stromquellen realisiert werden.

Das stufenförmige Summenstromsignal Iₛ wird durch die Filtereinrichtung 16 gefiltert. Die hohen Frequenzanteile des Summenstromsignals Iₛ am Knoten 38 werden durch den Tiefpaßfilter, der aus dem Widerstand 41 und dem Kondensator 42 besteht, gefiltert. Dabei werden die hochfrequenten Signalanteile über den Kondensator 42 auf Masse geleitet. Durch die Filterung werden die Stufen des treppenförmigen Summenstromsignals Iₛ, wie es in Fig. 4 gezeigt ist, abgeschliffen. Die an dem Knoten 38 gegenüber Masse anliegende gefilterte Spannung U wird durch den Spannungsstromwandler 44 in das Referenzstromsignal I_{ref} umgewandelt. Das Referenzstromsignal wird über die Leitung 2 dem Verstärker 3 zugeführt, welcher das an der Leitung 4 anliegende Sendesignal verstärkt und über die Ausgangsleitung 5 über eine Sendeantenne 45 abgibt.

Die in Fig. 3 gezeigte Schaltungsanordnung kann vorzugsweise in einen integrierten Schaltkreis integriert werden. Die Schalter 18, 19, 20 der Summationsschalteinrichtung 14 sind vorzugsweise steuerbare Halbleiterschaltbauelemente.

Die aus passiven Bauelementen aufgebaute Tiefpaßfiltereinrichtung kann bei einer weiteren Ausführungsform durch einen aktiven Tiefpaßfilter ersetzt werden.

Die Höhe der durch die Stromquellen 6, 7, 8, 9 erzeugten Ausgangsströme ist bei einer bevorzugten Ausführungsform extern einstellbar.

## Patentansprüche

1. Schaltvorrichtung zum Schalten eines durch einen Referenzstrom gesteuerten Verstärkers (3) mit
mehreren Stromquellen (6, 7, 8, 9), deren jeweilige Ausgangsströme durch eine Summationsschalteinrichtung (14) zur Erzeugung eines Summenstroms aufsummierbar sind, und mit
einer Filtereinrichtung (16), die die hochfrequenten Signalanteile des Summenstromes zur Erzeugung des Referenzstromes herausfiltert, wobei
die Summationsschalteinrichtung (14) mehrere parallel geschaltete steuerbare Schalter (18, 19, 20) aufweist, die jeweils mit einer Stromquelle (6, 7, 9) verbunden sind, und
die Schalter (18, 19, 20) jeweils über eine Steuerleitung (28, 29, 30) mit einer Steuerschaltung (21) verbunden sind, wobei
die Steuerschaltung (21) ein Schieberegister ist.

2. Schaltvorrichtung nach Anspruch 1, **dadurch gekennzeichnet, daß** das Schieberegister aus kettenförmig hintereinandergeschalteten Flip-Flops besteht, wobei die logischen Signalausgänge der Flip-Flops jeweils mit einer Steuerleitung (28, 29, 30) eines zugehörigen Schalters (18, 19, 20) verbunden sind.

3. Schaltvorrichtung nach Anspruch 2, **dadurch gekennzeichnet, daß** die Flip-Flops flankengetriggerte D-Flip-Flops sind.

4. Schaltvorrichtung nach Anspruch 3, **dadurch gekennzeichnet, daß** die Takteingänge der D-Flip-Flops über eine Taktleitung an eine Takterzeugungseinrichtung angeschlossen sind.

5. Schaltvorrichtung nach Anspruch 1 bis 4, **dadurch gekennzeichnet, daß** an dem Schieberegistereingang (35) des ersten Flip-Flops (22) ein Steuersignal angelegt wird, das zwischen einem ersten logischen Zustand zum Einschalten des Verstärkers (3) und einem zweiten logischen Zustand zum Ausschalten des Verstärkers (3) umschaltbar ist.

6. Schaltvorrichtung nach einem der vorangehenden Ansprüche, **dadurch gekennzeichnet, daß** die Filtereinrichtung (16) mindestens ein RC-Tiefpaßfilter (41, 42) aufweist.

7. Schaltvorrichtung nach Anspruch 6, **dadurch gekennzeichnet, daß** der Summenstrom an dem RC-Tiefpaßfilter (41, 42) eine Spannung erzeugt, die durch einen Spannungs-/Stromwandler (44) zur Erzeugung des Referenzstromes umgewandelt wird.

8. Schaltvorrichtung nach einem der vorangehenden Ansprüche, **dadurch gekennzeichnet, daß** die Höhe der durch die Stromquellen (6, 7, 8, 9) erzeugten Ausgangsströme jeweils einstellbar ist.

9. Schaltvorrichtung nach einem der vorangehenden Ansprüche, **dadurch gekennzeichnet, daß** der Verstärker (3) ein digitales Zeitmultiplexsignal verstärkt.

10. Schaltvorrichtung nach Anspruch 9, **dadurch gekennzeichnet, daß** das Zeitmultiplexsignal mehrere Rahmen aufweist, die jeweils in Zeitschlitze unterteilt sind.

11. Schaltvorrichtung nach einem der vorangehenden Ansprüche, **dadurch gekennzeichnet, daß** der Zeitschlitz ein Einschaltzeitfenster und ein Ausschaltzeitfenster besitzt.

12. Schaltvorrichtung nach Anspruch 11, **dadurch gekennzeichnet, daß** der Verstärker (3) innerhalb eines Zeitfensters umschaltbar ist.

13. Schaltvorrichtung nach Anspruch 11 oder 12, **dadurch gekennzeichnet, daß** die Dauer des Zeitfensters 10 µs beträgt.

14. Schaltvorrichtung nach einem der vorangehenden Ansprüche, **dadurch gekennzeichnet, daß** der Verstärker (3) ein Sendesignalverstärker ist, dessen Ausgang mit einer Sendeantenne (45) verbunden ist.

## Claims

1. Switching device for switching an amplifier (3) which is controlled by a reference current and has a plurality of power sources (6, 7, 8, 9) whose respective output currents can be summed by a summing switching device (14) in order to generate a summation current, and having a filter device (16) which filters out the radio-frequency signal components of the summation current in order to generate the reference current, the summing switching device (14) having a plurality of controllable switches (18, 19, 20) which are connected in parallel and are each connected to a power source (6, 7, 9), and
the switches (18, 19, 20) each being connected to a control circuit (21) via a control line (28, 29, 30), the control circuit (21) being a shift register.

2. Switching device according to Claim 1, **characterized in that** the shift register is composed of flip-flops which are connected in series in the form of a chain, the logic signal outputs of the flip-flops each being connected to a control line (28, 29, 30) of an associated switch (18, 19, 20).

3. Switching device according to Claim 2, **characterized in that** the flip-flops are edge-triggered D flip-flops.

4. Switching device according to Claim 3, **characterized in that** the clock inputs of the D flip-flops are connected to a clock-generating device via a clock line.

5. Switching device according to Claims 1 to 4, **characterized in that** a control signal which can be switched over between a first logic state for switching on the amplifier (3) and a second logic state for switching off the amplifier (3) is applied to the shift register input (35) of the first flip-flop (22).

6. Switching device according to one of the preceding claims, **characterized in that** the filter device (16) has at least one RC low-pass filter (41, 42).

7. Switching device according to Claim 6, **characterized in that** the summation current at the RC low-pass filter (41, 42) generates a voltage which is transformed by a voltage/current transformer (44) in order to generate the reference current.

8. Switching device according to one of the preceding claims, **characterized in that** the level of the output currents which are generated by the power sources (6, 7, 8, 9) can be adjusted in each case.

9. Switching device according to one of the preceding claims, **characterized in that** the amplifier (3) amplifies a digital time-division multiplex signal.

10. Switching device according to Claim 9, **characterized in that** the time-division multiplex signal has a plurality of frames which are each subdivided into time slots.

11. Switching device according to one of the preceding claims, **characterized in that** the time slot has a switch-on time window and a switch-off time window.

12. Switching device according to Claim 11, **characterized in that** the amplifier (3) can be switched over within one time window.

13. Switching device according to Claim 11 or 12, **characterized in that** the length of the time window is 10 µs.

14. Switching device according to one of the preceding claims, **characterized in that** the amplifier (3) is a transmission signal amplifier whose output is connected to a transmission antenna (45).

## Revendications

1. Dispositif de connexion d'un amplificateur (3) commandé par un courant de référence à plusieurs sources (6, 7, 8, 9) de courant, dont les courants respectifs de sortie peuvent être sommés par un dispositif (14) de sommation pour produire un courant somme et comprenant
un dispositif (16) de filtrage qui élimine les composantes de signal à haute fréquence du courant somme par filtration pour produire le courant de référence, dans lequel
le dispositif (14) de sommation a plusieurs interrupteurs (18, 19, 20) qui sont montés en parallèle, qui peuvent être commandés et qui sont reliés respectivement à une source (6, 7, 9) de courant et
les interrupteurs (18, 19, 20) sont reliés respectivement par une ligne (28, 29, 30) de commande à un circuit (21) de commande, dans lequel - le circuit (21) de commande est un registre à décalage.

2. Dispositif de connexion suivant la revendication 1, **caractérisé en ce que** le registre à décalage est constitué de bascules montées les unes derrière les autres sous la forme d'une chaîne, les sorties logiques de signaux des bascules étant reliées respectivement à une ligne (28, 29, 30) de commande d'un interrupteur (18, 19, 20) associé.

3. Dispositif de connexion suivant la revendication 2, **caractérisé en ce que** les bascules sont des bascules de type D à déclenchement par le front.

4. Dispositif de connexion suivant la revendication 3, **caractérisé en ce que** les entrées d'horloge des bascules de type D sont raccordées par une ligne d'horloge à un dispositif de production de signaux d'horloge.

5. Dispositif de connexion suivant la revendication 1 à 4, **caractérisé en ce qu'**il est appliqué à l'entrée (35) du registre à décalage de la première bascule (22) un signal de commande qui peut être commuté entre un premier état logique de connexion de l'amplificateur (3) et un deuxième état logique de déconnexion de l'amplificateur (3).

6. Dispositif de connexion suivant l'une des revendications précédentes, **caractérisé en ce que** le dispositif (16) de filtrage comporte au moins un filtre (41, 42) passe-bas RC.

7. Dispositif de connexion suivant la revendication 6, **caractérisé en ce que** le courant somme produit sur le filtre (41, 42) de passe-bas RC une tension qui est transformée par un convertisseur (44) tension /courant pour la production du courant de référence.

8. Dispositif de connexion suivant l'une des revendications précédentes, **caractérisé en ce que** le niveau des courants de sortie produits par les sources (6, 7, 8, 9) de courant est respectivement réglable.

9. Dispositif de connexion suivant l'une des revendications précédentes, **caractérisé en ce que** l'amplificateur (3) amplifie un signal numérique à multiplexage dans le temps.

10. Dispositif de connexion suivant la revendication 9, **caractérisé en ce que** le signal à multiplexage dans le temps a plusieurs cadres qui sont subdivisés respectivement en créneaux temporels.

11. Dispositif de connexion suivant l'une des revendications précédentes, **caractérisé en ce que** le créneau temporel a une fenêtre temporelle de connexion et une fenêtre temporelle de déconnexion.

12. Dispositif de connexion suivant la revendication 11, **caractérisé en ce que** l'amplificateur (3) peut être commuté dans une fenêtre temporelle.

13. Dispositif de connexion suivant la revendication 11 ou 12, **caractérisé en ce que** la durée de la fenêtre temporelle est de 10 µs.

14. Dispositif de connexion suivant l'une des revendications précédentes, **caractérisé en ce que** l'amplificateur (3) est un amplificateur de signal d'émission, dont la sortie est reliée à une antenne (45) d'émission.
